# EUROPÄISCHE PATENTANMELDUNG

(11) **EP 0 955 562 A1**
(43) Veröffentlichungstag der Anmeldung: **10.11.1999**
(21) Anmeldenummer: 99108168.8
(22) Anmeldetag: 26.04.1999
(51) Int. Cl.: G03F 7/004

(54) **Chemisch verstärkter Resist**

(30) Priorität: 07.05.1998 DE 19820477
(71) Anmelder: SIEMENS AKTIENGESELLSCHAFT, 80333 München (DE)
(72) Erfinder: Hien, Stefan Dr., 91058 Erlangen (DE)

(57) **Zusammenfassung**

Der chemisch verstärkte Resist nach der Erfindung enthält folgende Komponenten:
- ein säurelabile Gruppen aufweisendes Polymer aus wenigstens zwei Polymerbausteinen,
- eine erste photoaktive Oniumverbindung (A), die bei Belichtung oder Elektronenbestrahlung eine Sulfonsäure mit einem pKₐ-Wert ≤ 0 freisetzt,
- eine zweite photoaktive Oniumverbindung (B), die bei Belichtung oder Elektronenbestrahlung eine Sulfonsäure mit einem pKₐ-Wert ≤ 3 freisetzt, wobei dieser pKₐ-Wert mindestens um den Wert 1 größer ist als der pKₐ-Wert der Oniumverbindung (A),
- ein Lösemittel.

## Beschreibung

Die Erfindung betrifft einen chemisch verstärkten Resist.

In der Mikroelektronik werden für die optische Lithographie Photoresists eingesetzt, insbesondere auch sogenannte chemisch verstärkte Resists ( 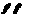 chemically amplified resists"). Bei derartigen Resists wird die katalytische Wirkung eines photochemisch generierten Protons auf die Abspaltung einer säurelabilen Schutzgruppe ausgenutzt. Dieser Mechanismus der chemisch verstärkten Resists bzw. Photolacke birgt jedoch folgende Nachteile in sich, die bei der Entwicklung der belichteten Strukturen zutage treten:
- Hohe Sensitivität gegenüber basischen Verunreinigungen aus der Luft oder aus dem verwendeten Substrat. Daraus resultieren massive Unregelmäßigkeiten der Strukturen. Die Profile werden an der Grenzfläche zum Substrat hin breiter (Fußbildung; footing), und an der Grenzfläche zur Luft bilden sich ebenfalls Verbreiterungen aus, die allgemein als T-tops (T-shaped profiles) bekannt sind (siehe dazu: Proc. SPIE Vol. 1466 (1991), Seiten 2 bis 12 und 13 bis 25).
- Ausgeprägte Instabilität des latenten Bildes nach der Belichtung. Dies bedeutet, daß die nominale Strukturgröße auf der Maske bei verschiedenen Wartezeiten vom Resist unterschiedlich wiedergegeben wird. Je länger diese Wartezeit nach der Belichtung wird, umso geringer wird die Auflösung des Resistmaterials. Bei anhydridgruppenhaltigen Resists, wie sie beispielsweise aus EP-OS 0 492 256 bekannt sind, können bereits nach wenigen Minuten nur noch Strukturen aufgelöst werden, die größer als 250 nm sind.

Zur Beseitigung der genannten Probleme sind bereits verschiedene Möglichkeiten bekannt (siehe dazu: J. Photopolym. Sci. Technol. Vol. 8 (1995), Seiten 505 bis 518). Neben der Verwendung von Aktivkohleclustern zur Luftreinigung werden dabei organische Schutzschichten und Polymere mit niedrigem freien Volumen vorgeschlagen. Eine weitere Möglichkeit ist die Verwendung von Schutzgruppen, die relativ leicht abspaltbar sind; hierzu dienen insbesondere tert.-Butoxycarbonyl- und Tetrahydropyranyl-Schutzgruppen. Ein Nachteil derartiger Lacksysteme ist jedoch die geringe Lagerstabilität vor der Belackung und Belichtung.

Darüber hinaus wurde auch bereits die Verwendung von basischen Additiven empfohlen. Dabei ist zwischen photoempfindlichen Additiven und gegenüber aktinischer Strahlung unempfindlichen Substanzen zu unterscheiden; Beispiele für letztere sind N-Methylpyrrolidon (siehe: Jpn. J. Appl. Phys. Vol. 33 (1994), Pt. 1, Seiten 7023 bis 7027) und quartäre Ammoniumsalze (siehe: US-PS 5 609 989 und EP-OS 0 762 207). Bei der Reaktion dieser Basen mit einem freien Proton stellt sich ein Puffergleichgewicht ein. Dieses Gleichgewicht ist der Garant für eine konstante Säurekonzentration in den belichteten Bereichen eines Resists bei der eigentlichen Abspaltungsreaktion während eines Temperschrittes (PEB-Schritt). Ein Nachteil dieser Systeme ist jedoch der relativ hohe Anstieg der Dosiswerte.

Als photolabile Basen werden beispielsweise Diaryliodonium- und Triarylsulfoniumhydroxyde sowie die entsprechenden Alkoxyde und Acetate eingesetzt (siehe: EP-OS 0 611 998 und EP-OS 0 756 203). Hierbei wird in den belichteten Bereichen eines Photoresists die Base zerstört, während sie in den unbelichteten Bereichen durch Diffusion eindringende Säure abfängt. In den beschriebenen Systemen werden leicht abspaltbare Schutzgruppen (Acetale) verwendet, die sich auch ohne Pufferung relativ stabil gegenüber basischen Luftverunreinigungen verhalten.

Aufgabe der Erfindung ist es, einen neuartigen chemisch verstärkten Resist bereitzustellen, der sowohl hochempfindlich ist als auch eine Kontrastverstärkung und eine Stabilisierung des latenten Bildes bewirkt.

Dies wird erfindungsgemäß durch einen Resist erreicht, der folgende Komponenten enthält:
- ein säurelabile Gruppen aufweisendes Polymer aus wenigstens zwei Polymerbausteinen,
- eine erste photoaktive Oniumverbindung (A), die bei Belichtung oder Elektronenbestrahlung eine Sulfonsäure mit einem pKₐ-Wert ≤ 0 freisetzt,
- eine zweite photoaktive Oniumverbindung (B), die bei Belichtung oder Elektronenbestrahlung eine Sulfonsäure mit einem pKₐ-Wert ≤ 3 freisetzt, wobei dieser pKₐ-Wert mindestens um den Wert 1 größer ist als der pKₐ-Wert der Oniumverbindung (A),
- ein Lösemittel.

Der chemisch verstärkte Resist nach der Erfindung eignet sich insbesondere für die Belichtung im nahen UV, beispielsweise bei 193 und 248 mm, er kann aber auch für das Elektronenstrahlschreiben eingesetzt, d.h. mit Elektronen bestrahlt werden. Bei diesem Resist finden insbesondere solche Schutzgruppen Verwendung, die erst bei hohen Temperaturen säurekatalytisch abgespaltet werden, beispielweise tert.-Butylestergruppen. Als Basispolymer können dabei grundsätzlich alle Copolymeren - in Form von Bi-, Ter- oder Quaterpolymeren - eingesetzt werden, die bei der Belichtungswellenlänge eine ausreichend hohe Transparenz besitzen und geeignete säurelabile Schutzgruppen tragen.

Das wesentliche Merkmal des Resists nach der Erfindung besteht darin, daß als photoaktive Verbindung, d.h. als Photosäuregenerator, zwei photoaktive Oniumverbindungen eingesetzt werden, die bei der Belichtung bzw. Elektronenbestrahlung zwei unterschiedlich starke Sulfonsäuren freisetzen. Überraschenderweise wurde nämlich gefunden, daß bei der Verwendung von zwei unterschiedlichen Onium-Photosäuregeneratoren Strukturen erhalten werden, die auch bei einer längeren Standzeit (bis zu 24 Stunden) nach der Belichtung unter ungereinigter Laboratmosphäre frei von Footing- und T-top-Defekten sind. Außerdem ergibt sich bei positiv arbeitenden Resistsystemen eine deutliche Kontrastverstärkung von -4 auf -8.

Als Sulfonsäure mit einem pKₐ-Wert ≤ 3 kommen Säuren wie p-Toluolsulfonsäure (pKₐ = -7), Hexadecylsulfonsäure (pKₐ = -2), Cyclohexansulfonsäure (pKₐ = 2,4) und Camphersulfonsäure (pKₐ = -1) in Betracht und als Sulfonsäure mit einem pKₐ-Wert ≤ 0 teilweise oder perfluorierte Alkansulfonsäuren, wie Trifluormethansulfonsäure (pKₐ = -20). Wichtig ist hierbei, daß sich die pKₐ-Werte der generierten Säuren deutlich unterscheiden. Im allgemeinen werden photoaktive Oniumverbindungen verwendet, aus denen Sulfonsäuren freigesetzt werden, deren pKₐ-Wert im Bereich von -20 bis 3 liegt. Der pKₐ-Wert ist im übrigen der sogenannte Säureexponent (negativer dekadischer Logarithmus der Säurekonstante Kₐ).

Die im Resist nach der Erfindung eingesetzten Photosäuregeneratoren sind insbesondere ionische Verbindungen in Form von Sulfoniumsalzen R₃S⁺X⁻ und Iodoniumsalzen R₂I⁺X⁻. Die Reste R, die gleich oder verschieden sind, können entweder eine aliphatische oder eine aromatische Grundstruktur besitzen. Die aromatischen Reste können dabei mit aliphatischen oder weiteren aromatischen Resten substituiert sein, wobei aliphatische Reste bevorzugt werden, die die Löslichkeit der Verbindungen erhöhen, beispielsweise tert.-Butylgruppen. Vorteilhaft finden Photogeneratoren Verwendung, die das gleiche Kation aufweisen; es können aber auch verschiedene Kationen nebeneinander vorliegen.

Für bevorzugte Resists nach der Erfindung gilt folgendes:
1) Die Oniumverbindung (A) und/oder (B) ist ein Oniumsalz der Struktur R₃S⁺X⁻ oder R₂I⁺X⁻, wobei die Reste R gleich oder verschieden sein können und jeweils einen aliphatischen, aromatischen oder Aryl-carbonyl-alkylen-Rest bedeuten oder zwei Reste R zusammen einen Alkylenrest bilden. Besonders bevorzugt steht R für C₁- bis C₁₂-Alkyl, (C₆- bis C₁₄-Aryl)-CO-CH₂- oder C₆- bis C₁₂-Aryl, wobei die Arylreste auch N-, O- oder S-Atome aufweisen können, oder zwei Reste R bedeuten zusammen Tetramethylen -(CH₂)₄-.
   Die aromatischen Reste R können auch ein- oder mehrfach mit OH-, NO₂-, Halogen- oder Alkoxygruppen, insbesondere mit C₁- bis C₄-Alkylresten, substituiert sein. Ferner können die aromatischen Reste R gegebenenfalls mit aliphatischen oder weiteren aromatischen Resten substituiert sein, insbesondere mit C₁- bis C₁₂-Alkyl oder C₆- bis C₁₄-Aryl.
2) Die Oniumverbindung (A) ist ein Oniumsalz der Struktur R₃S⁺X⁻ oder R₂I⁺X⁻, wobei X⁻ folgende Bedeutung haben kann:
   - Eine einfach, mehrfach oder perhalogenierte aliphatische Sulfonatgruppe, insbesondere eine C₁- bis C₁₂-Alkylsulfonatgruppe, beispielsweise eine Trifluormethan- oder Nonafluorbutansulfonatgruppe;
   - eine einfach, mehrfach oder perhalogenierte aromatische Sulfonatgruppe, insbesondere eine C₆- bis C₁₄-Arylsulfonatgruppe, beispielsweise eine Pentafluorbenzolsulfonatgruppe;
   - eine ein- oder mehrfach mit einem Elektronenakzeptor substituierte aromatische Sulfonatgruppe, insbesondere eine mit NO₂, CN oder Halogen substituierte C₆- bis C₁₂-Arylsulfonatgruppe, beispielsweise eine Dinitrobenzolsulfonatgruppe;
   - eine ein- oder mehrfach alkylsubstituierte aromatische Sulfonatgruppe, insbesondere eine mit C₁- bis C₄-Alkyl substituierte C₆- bis C₁₄-Arylsulfonatgruppe, beispielsweise eine Toluol- oder Naphthalinsulfonatgruppe.
3) Die Oniumverbindung (B) ist ein Oniumsalz der Struktur R₃S⁺X⁻ oder R₂I⁺X⁻, wobei X⁻ folgende Bedeutung haben kann:
   - Eine lineare oder verzweigte aliphatische oder cyclische Sulfonatgruppe, insbesondere eine C₁- bis C₁₆-Alkyl- bzw. -cycloalkylsulfonatgruppe, beispielsweise eine Hexadecyl-, Cyclohexan- oder Camphersulfonatgruppe (C₁₀H₁₅O-SO₃⁻)^{;}
   - eine ein- oder mehrfach alkylsubstituierte aromatische Sulfonatgruppe, insbesondere eine mit C₁- bis C₄-Alkyl substituierte C₆- bis C₁₄-Arylsulfonatgruppe, beispielsweise eine Toluol- oder Naphthalinsulfonatgruppe.
4) Einer der Polymerbausteine bzw. eine der Struktureinheiten (des Copolymers) weist säurelabile Gruppen auf, insbesondere Tetrahydrofuranylester-, Tetrahydropyranylester- oder tert.-Alkylestergruppen, vorzugsweise mit C₄- bis C₁₀-Alkyl, beispielsweise tert.-Butylestergruppen.
5) Dem Polymer, d.h. dem Copolymer, liegt wenigstens einer der folgenden Polymerbausteine zugrunde:
   - Methacrylsäure
   - Methacrylsäurealkylester, insbesondere mit C₁- bis C₁₂-Alkyl, beispielsweise tert.-Butylmethacrylat
   - Fumarsäure-mono-tert.-butylester
   - Maleinsäureanhydrid
   - siliciumhaltiges Monomer, insbesondere Allyltrimethylsilan.
6) Das Lösemittel ist Methoxypropylacetat, Cyclopentanon, Cyclohexanon, γ-Butyrolacton, Ethyllactat oder ein Gemisch aus wenigstens zwei dieser Verbindungen. Allgemein können aber alle gängigen Photolack-Lösemittel eingesetzt werden.

Die Resists nach der Erfindung können nach der Entwicklung direkt als Ätzmaske bei einer Substratstrukturierung verwendet werden (Einlagenresist) oder auch in einem geeigneten Folgeschritt einer weiteren Prozessierung unterworfen werden, wie dies für Zweilagenresists bekannt ist. Diese Resists eignen sich insbesondere als CARL-Zweilagenresists (siehe dazu: Microelectr. Eng. Vol. 11 (1990), Seiten 531 bis 534). Hierbei werden in einem naßchemischen Silylierungsschritt die bereits entwickelten Strukturen verstärkt (CARL = Chemical Amplification of Resist Lines), und erst anschließend wird in einem Sauerstoffplasma die darunter liegende Antireflexschicht anisotrop trockengeätzt. Dadurch entstehen Strukturen mit besonders steilen Flanken und hohem Aspektverhältnis.

Anhand von Ausführungsbeispielen soll die Erfindung noch näher erläutert werden (GT = Gewichtsteile).

### Beispiel 1 (Vergleichsversuch)

### Herstellung eines Photolacks für die Belichtung im tiefen UV

7,6 GT eines Polymers, hergestellt durch radikalische Copolymerisation von Maleinsäureanhydrid mit Methacrylsäure-tert.-butylester und Allyltrimethylsilan (Molekulargewicht: 15000 g/mol), werden zusammen mit 0,4 GT Triphenylsulfonium-trifluormethansulfonat in 92 GT Cyclohexanon gelöst. Durch anschließende Filtration der Lösung über ein 0,2 µm-Feinstfilter erhält man eine gebrauchsfertige Photolackmischung für die Belichtung im tiefen UV, beispielsweise bei 248 oder 193 nm.

### Beispiel 2

### Herstellung eines hochempfindlichen Photolacks für die Belichtung im tiefen UV

7,6 GT eines Polymers, hergestellt durch radikalische Copolymerisation von Maleinsäureanhydrid mit Methacrylsäure-tert.-butylester und Allyltrimethylsilan (Molekulargewicht: 15000 g/mol), werden zusammen mit 0,4 GT Triphenylsulfonium-trifluormethansulfonat und 0,04 GT Triphenylsulfonium-tosylat in 92 GT Cyclohexanon gelöst. Durch anschließende Filtration der Lösung über ein 0,2 µm-Feinstfilter erhält man eine gebrauchsfertige Photolackmischung für die Belichtung im tiefen UV, beispielsweise bei 248 oder 193 nm.

### Beispiel 3 (Vergleichsversuch)

### Herstellung eines Photolacks für die Belichtung im tiefen UV

7,6 GT eines Polymers, hergestellt durch radikalische Copolymerisation von Maleinsäureanhydrid mit Methacrylsäure-tert.-butylester und Methacrylsäure (Molekulargewicht: 15000 g/mol), werden zusammen mit 0,4 GT Bis-(4-tert.-butylphenyl)-iodonium--nonafluorbutansulfonat in 92 GT Cyclohexanon gelöst. Durch anschließende Filtration der Lösung über ein 0,2 µm-Feinstfilter erhält man eine gebrauchsfertige Photolackmischung für die Belichtung im tiefen UV, beispielsweise bei 248 oder 193 nm.

### Beispiel 4

### Herstellung eines hochempfindlichen Photolacks für die Belichtung im tiefen UV

7,6 GT eines Polymers, hergestellt durch radikalische Copolymerisation von Maleinsäureanhydrid mit Methacrylsäure-tert.-butylester und Methacrylsäure (Molekulargewicht: 15000 g/mol), werden zusammen mit 0,4 GT Bis-(4-tert.-butylphenyl)-iodonium-nonafluorbutansulfonat und 0,04 GT Triphenylsulfonium-camphersulfonat in 92 GT Cyclohexanon gelöst. Durch anschließende Filtration über ein 0,2 µm-Feinstfilter erhält man eine gebrauchsfertige Photolackmischung für die Belichtung im tiefen UV, beispielsweise bei 248 oder 193 nm.

### Beispiel 5

### Herstellung einer lichtempfindlichen Photolackschicht

Auf Siliciumscheiben wird bei 4500 min⁻¹ jeweils eine Lösung von 12,5 GT Novolak in 75 GT Propylenglykolmonomethyletheracetat aufgeschleudert, anschließend wird bei 225°C/2 min auf einer Heizplatte ausgeheizt. Auf die hierbei erhaltene 0,6 µm dicke lichtabsorbierende Schicht wird durch Aufschleudern der Photolackmischungen entsprechend den Beispielen 1 bis 4 bei 2500 min⁻¹ und Trocknen bei 140°C/60 s auf der Heizplatte jeweils eine 0,2 µm dicke lichtempfindliche Schicht aufgebracht.

### Beispiel 6 (Vergleichsversuch)

### Herstellung von positiven Photolackstrukturen (Zweilagentechnik)

Auf die entsprechend Beispiel 5 mit der Photolackmischung nach Beispiel 1 hergestellte lichtempfindliche Photolackschicht wird mittels eines 248 nm-Projektionsbelichtungsgerätes bei einer Dosis von 20 mJ/cm² das Bild einer Maske projiziert, welche Steg/Graben-Strukturen im Raster von 0,40 bis 0,14 µm aufweist. Anschließend wird auf einer Heizplatte bei 130°C/60 s getempert. Die Schicht wird dann mit einem 0,26 N Tetramethylainmoniumhydroxid-Entwickler 60 s im Puddleverfahren entwickelt und nachfolgend bei 100°C/60 s auf der Heizplatte getempert. Es werden 0,2 µm hohe Steg/Graben-Strukturen im Raster bis 0,20 µm aufgelöst. Ein Bruch durch die Lackstege zeigt im Rasterelektronenmikroskop deutliches Footing und T-top-Ausbildung. Die erzielten Steg/Graben-Strukuren können bei gleicher Dosis an verschiedenen Tagen nicht reproduziert werden. Strukturbreite und Form sind abhängig von der jeweiligen Luftqualität im Reinraum. Standzeiten größer als 30 min nach der Belackung oder Belichtung reduzieren das Auflösungsvermögen.

### Beispiel 7

### Herstellung von positiven Photolackstrukturen (Zweilagentechnik)

Auf die entsprechend Beispiel 5 mit der Photolackmischung nach Beispiel 2 hergestellte lichtempfindliche Photolackschicht wird mittels eines 248 nm-Projektionsbelichtungsgerätes bei einer Dosis von 25 mJ/cm² das Bild einer Maske projiziert, welche Steg/Graben-Strukturen im Raster von 0,40 bis 0,14 µm aufweist. Anschließend wird auf einer Heizplatte bei 130°C/60 s getempert. Die Schicht wird dann mit einem 0,26 N Tetramethylammoniumhydroxid-Entwickler 60 s im Puddleverfahren entwickelt und nachfolgend bei 100°C/60 s auf der Heizplatte getempert. Es werden 0,2 µm hohe Steg/Graben-Strukturen im Raster bis 0,15 µm aufgelöst. Ein Bruch durch die Lackstege zeigt im Rasterelektronenmikroskop steile Flanken. Die erzielten Steg/Graben-Strukuren können bei gleicher Dosis auch bei längeren Standzeiten im Reinraum (> 1 h) reproduziert werden. Strukturbreite und Form sind dabei unabhängig von der jeweiligen Luftqualität im Reinraum.

### Beispiel 8 (Vergleichsversuch)

### Herstellung von positiven Photolackstrukturen (Zweilagentechnik)

Auf die entsprechend Beispiel 5 mit der Photolackmischung nach Beispiel 3 hergestellte lichtempfindliche Photolackschicht wird mittels eines 248 nm-Projektionsbelichtungsgerätes bei einer Dosis von 28 mJ/cm² das Bild einer Maske projiziert, welche Steg/Graben-Strukturen im Raster von 0,40 bis 0,14 µm aufweist. Anschließend wird auf einer Heizplatte bei 130°C/60 s getempert. Die Schicht wird dann mit einem 0,26 N Tetramethylammoniumhydroxid-Entwickler 60 s im Puddleverfahren entwickelt und nachfolgend bei 100°C/60 s auf der Heizplatte getempert. Es werden 0,2 µm hohe Steg/Graben-Strukturen im Raster bis 0,22 µm aufgelöst. Ein Bruch durch die Lackstege zeigt im Rasterelektronenmikroskop deutliches Footing und T-top-Ausbildung. Die erzielten Steg/Graben-Strukuren können bei gleicher Dosis an verschiedenen Tagen nicht reproduziert werden. Strukturbreite und Form sind abhängig von der jeweiligen Luftqualität im Reinraum. Standzeiten größer als 30 min nach der Belackung oder Belichtung reduzieren das Auflösungsvermögen.

### Beispiel 9

### Herstellung von positiven Photolackstrukturen (Zweilagentechnik)

Auf die entsprechend Beispiel 5 mit der Photolackmischung nach Beispiel 4 hergestellte lichtempfindliche Photolackschicht wird mittels eines 248 nm-Projektionsbelichtungsgerätes bei einer Dosis von 33 mJ/cm² das Bild einer Maske projiziert, welche Steg/Graben-Strukturen im Raster von 0,40 bis 0,14 µm aufweist. Anschließend wird auf einer Heizplatte bei 130°C/60 s getempert. Die Schicht wird dann mit einem 0,26 N Tetramethylammoniumhydroxid-Entwickler 60 s im Puddleverfahren entwickelt und nachfolgend bei 100°C/60 s auf der Heizplatte getempert. Es werden 0,2 µm hohe Steg/Graben-Strukturen im Raster bis 0,15 µm aufgelöst. Ein Bruch durch diese Lackstege zeigt im Rasterelektronenmikroskop steile Flanken. Die erzielten Steg/Graben-Strukuren können bei gleicher Dosis auch bei längeren Standzeiten im Reinraum (> 1 h) reproduziert werden. Strukturbreite und Form sind dabei unabhängig von der jeweiligen Luftqualität im Reinraum.

### Beispiel 10

### Herstellung von positiven Photolackstrukturen (Einlagentechnik)

24,6 GT eines Polymers, hergestellt durch radikalische Copolymerisation von Methacrylsäure mit Methacrylsäure-tert.-butylester und Allyltrimethylsilan (Molekulargewicht: 15000 g/mol), werden zusammen mit 1,2 GT Triphenylsulfonium-trifluormethansulfonat und 0,12 GT Triphenylsulfonium-tosylat in 75 GT Cyclohexanon gelöst. Durch anschließende Filtration der Lösung über ein 0,2 µm-Feinstfilter erhält man eine gebrauchsfertige Photolackmischung für die Belichtung im tiefen UV, beispielsweise bei 248 oder 193 nm.

Durch Aufschleudern der Photolackmischung auf ein Substrat bei 2500 min⁻¹ und Trocknen bei 140°C/60 s auf einer Heizplatte wird eine 0,8 µm dicke lichtempfindliche Schicht hergestellt. Auf diese Schicht wird mittels eines 248 nm-Projektionsbelichtungsgerätes bei einer Dosis von 35 mJ/cm² das Bild einer Maske projiziert, welche Steg/Graben-Strukturen im Raster von 0,40 bis 0,14 µm aufweist. Anschließend wird auf der Heizplatte bei 130°C/60 s getempert. Die Schicht wird dann mit einem 0,26 N Tetramethylammoniumhydroxid-Entwickler 60 s im Puddleverfahren entwickelt. Es werden 0,8 µm hohe Steg/Graben-Strukturen im Raster bis 0,18 µm aufgelöst. Die erzielten Steg/Graben-Strukuren können bei gleicher Dosis auch bei längeren Standzeiten im Reinraum (> 1 h) reproduziert werden. Strukturbreite und Form sind dabei unabhängig von der jeweiligen Luftqualität im Reinraum.

## Patentansprüche

1. Chemisch verstärkter Resist, enthaltend
- ein säurelabile Gruppen aufweisendes Polymer aus wenigstens zwei Polymerbausteinen,
- eine erste photoaktive Oniumverbindung (A), die bei Belichtung oder Elektronenbestrahlung eine Sulfonsäure mit einem pKₐ-Wert ≤ 0 freisetzt,
- eine zweite photoaktive Oniumverbindung (B), die bei Belichtung oder Elektronenbestrahlung eine Sulfonsäure mit einem pKₐ-Wert ≤ 3 freisetzt, wobei dieser pKₐ-Wert mindestens um den Wert 1 größer ist als der pKₐ-Wert der Oniumverbindung (A),
- ein Lösemittel.

2. Resist nach Anspruch 1, **dadurch gekennzeichnet,** daß die Oniumverbindung (A) und/oder (B) ein Oniumsalz der Struktur R₃S⁺X⁻ oder R₂I⁺X⁻ ist, wobei die Reste R gleich oder verschieden sein können und jeweils einen aliphatischen, aromatischen oder Aryl-carbonyl-alkylen-Rest bedeuten oder zwei Reste R zusammen einen Alkylenrest bilden.

3. Resist nach Anspruch 2, **dadurch gekennzeichnet,** daß die Oniumverbindung (A) ein Oniumsalz der Struktur R₃S⁺X⁻ oder R₂I⁺X⁻ ist, wobei X⁻ folgende Bedeutung haben kann:
- eine einfach, mehrfach oder perhalogenierte aliphatische Sulfonatgruppe,
- eine einfach, mehrfach oder perhalogenierte aromatische Sulfonatgruppe,
- eine ein- oder mehrfach mit einem Elektronenakzeptor substituierte aromatische Sulfonatgruppe,
- eine ein- oder mehrfach alkylsubstituierte aromatische Sulfonatgruppe.

4. Resist nach Anspruch 2 oder 3, **dadurch gekennzeichnet,** daß die Oniumverbindung (B) ein Oniumsalz der Struktur R₃S⁺X⁻ oder R₂I⁺X⁻ ist, wobei X⁻ folgende Bedeutung haben kann:
- eine lineare oder verzweigte aliphatische oder cyclische Sulfonatgruppe,
- eine ein- oder mehrfach alkylsubstituierte aromatische Sulfonatgruppe.

5. Resist nach einem oder mehreren der Ansprüche 1 bis 4, **dadurch gekennzeichnet,** daß einer der Polymerbausteine säurelabile Gruppen aufweist, insbesondere tert.-Alkylester-, Tetrahydrofuranylester- oder Tetrahydropyranylestergruppen.

6. Resist nach einem oder mehreren der Ansprüche 1 bis 5, **dadurch gekennzeichnet,** daß dem Polymer wenigstens einer der folgenden Polymerbausteine zugrunde liegt:
- Methacrylsäure
- Methacrylsäurealkylester
- Fumarsäure-mono-tert.-butylester
- Maleinsäureanhydrid
- siliciumhaltiges Monomer.

7. Resist nach einem oder mehreren der Ansprüche 1 bis 6, **dadurch gekennzeichnet,** daß das Lösemittel Methoxypropylacetat, Cyclopentanon, Cyclohexanon, γ-Butyrolacton, Ethyllactat oder ein Gemisch aus wenigstens zwei dieser Verbindungen ist.
